(19) Europäisches Patentamt
European Patent Office
Office européen des brevets

(11) **EP 2 169 828 B1**

(12) **EUROPEAN PATENT SPECIFICATION**

(45) Date of publication and mention
of the grant of the patent:
**22.03.2017 Bulletin 2017/12**

(51) Int Cl.:
*H03L 7/093* (2006.01)     *H03L 7/18* (2006.01)
*H03L 7/107* (2006.01)

(21) Application number: **08016921.2**

(22) Date of filing: **25.09.2008**

(54) **Variable capacitance circuit and method for providing a variable capacitance**

Schaltkreis mit variabler Kapazität und Verfahren zur Herstellung einer variablen Kapazität

Circuit à capacité variable et procédé pour fournir une capacité variable

(84) Designated Contracting States:
**AT BE BG CH CY CZ DE DK EE ES FI FR GB GR HR HU IE IS IT LI LT LU LV MC MT NL NO PL PT RO SE SI SK TR**

(43) Date of publication of application:
**31.03.2010 Bulletin 2010/13**

(73) Proprietor: **ams AG**
**8141 Unterpremstätten (AT)**

(72) Inventor: **Gajdardziew, Andrzej**
**8323 St. Marein B. Graz (AT)**

(74) Representative: **Epping - Hermann - Fischer Patentanwaltsgesellschaft mbH**
**Schloßschmidstraße 5**
**80639 München (DE)**

(56) References cited:
**WO-A-2004/079914**     **GB-A- 2 443 784**
**US-A1- 2003 227 341**     **US-A1- 2006 022 726**
**US-A1- 2006 135 105**     **US-A1- 2007 152 758**

**Description**

A lot of analog circuits require a variation of the built-in capacitances. One example is a conventional analog phase-locked loop, PLL, which can be employed in many frequency agile electronic systems, such as but not limited to radio transceivers, spectrum analyzers and sensor interfaces. Such a PLL is described by a set of transfer function characteristics that can be analyzed in the frequency domain, the so-called S plane, by the location of poles and zeros. For example, the pole and zero locations of the low pass filter of a second order PLL determine the bandwidth and the damping factor of the PLL. These in turn characterize the phase lock acquisition process, especially the duration of the process before the feedback loop acquires phase coherence with a predetermined residual error. Furthermore, there is an intrinsic trade-off between the PLL lock-in time and the PLL bandwidth, such that a fast lock-in time results in a wide PLL bandwidth, and vice-versa. Another trade-off exists between the PLL bandwidth and properties of the PLL output signal. A wide bandwidth results in poor reference frequency spur attenuation, and vice-versa. In addition, PLL bandwidth influences the output phase noise shaping.

The above-mentioned frequency agile electronic systems often require an analog PLL which realizes both, namely acquiring a lock condition as fast as is characterized by a wideband PLL and providing properties of the output signal as characterized by a narrowband PLL. One example could be a spectrum analyzer device which is implemented as part of a low-cost, low-power integrated circuit. This would employ a second order PLL performing many thousands of measurements involving the full PLL lock-in process. The settling time of the PLL directly adds up to the time per measurement and hence also to the time required by the device to provide the final output data.

As known in the art, such PLL trade-off can be implemented by a dynamically varied PLL bandwidth. That means that during the initial PLL lock-in process, a wide bandwidth is selected allowing fast loop settling. After reaching loop steady or near steady state condition, a narrow bandwidth is selected allowing for PLL output signal properties as characterized by a narrow band PLL. In this configuration, the PLL bandwidth is remotely varied by appropriate change of its transfer function characteristics. This can be, for example, a pole-zero relocation in the loop low pass filter transfer function. One possibility to realize this is by variation of the values of resistors and capacitors of the low pass filter. In existing implementations, a variation of capacitances is typically achieved by switching of several discrete capacitors until the desired value is completed. This capacitor switching results in a charge transfer, applying a relatively large voltage step to the error signal of a PLL. This leads to significant loop disturbance from the stationary condition, essentially driving the PLL out of phase coherence. The voltage step magnitude as a result of the charge transfer is emphasized by the fact that the PLL bandwidth is reduced in the process, resulting in prolonged residual settling. This effect limits the application of second order analog PLLs in a number of fast frequency tuning applications.

WO 2004/079914 shows a phase-locked loop, PLL, circuit comprising a loop filter with a first and a second bandwidth.

US 2006/0135105 A1 describes a loop filter with gear shift for improved fractional-N PLL settling time which is used in radio frequency transmitters. A multi-mode loop filter is disclosed, which is operable to provide a wideband response with a fast settle time in a start-up mode of operation and a relatively more narrow response with a longer settle time and improved filtering in a steady state mode of operation.

US 2003/0227341 A1 presents a voltage-controlled oscillator and frequency synthesizer. The document also describes a state of the art VCO with two tank circuits. Each tank circuit is formed by an inductor and a variable capacitor group. A negative resistance generating circuit is coupled between the two tank circuits.

It is an objective of the invention to provide a variable capacitance circuit and a method for providing a variable capacitance which minimize disturbing a loop circuit during pole-zero relocation or bandwidth variation.
The objective is achieved with the subject matter of the independent patent claims. Embodiments and developments of the invention are subject matter of the dependent claims.
In one exemplary embodiment, a variable capacitance circuit comprises a first capacitance, a second capacitance, and a switchable connection between a first and a second terminal. The first capacitance is coupled between the first terminal and a reference potential terminal. The second capacitance is coupled between the second terminal and the reference potential terminal. The switchable connection between the first and the second terminal is configured such that in a first mode of operation, the value of the first capacitance is provided at the first terminal. In a second mode of operation, a sum of the values of the first and the second capacitances is provided at the first terminal. The variable capacitance circuit is characterized by further comprising a buffer. In the first mode of operation, the buffer is effectively coupled between the first terminal and the second terminal via a first switch. In the second mode of operation, the first terminal is effectively connected to the second terminal via a second switch.
During the first mode of operation, the first capacitance is charged and the second capacitance is pre-charged using the switchable connection between the first and the second terminals. The value of the first capacitance is provided at the first terminal. In the second mode of operation, the first capacitance is effectively combined with the second capacitance and the value of the combined capacitances is provided at the first terminal. This change or variation of capacitances corresponds to a pole-zero relocation in the S plane.

By creating the initial charge build-up on the second capacitance during the first mode of operation, a significant charge transfer is avoided when switching to the second mode of operation where the first and the second capacitances are combined. Therefore, the loop disturbance is minimized.

A directional signal can be derived which corresponds to the value of the capacitance provided at the first terminal. In the first mode of operation, the directional signal is derived from the value of the first capacitance. In the second mode of operation, the directional signal is derived from the sum of the values of the first and second capacitances. The buffer also can be designated as a voltage buffer, unity gain buffer, voltage follower or driver.

In the first mode of operation, the first switch is closed or it is on and the second switch is open or off. This enables a pre-charging of the second capacitance. In the second mode of operation, the second switch is closed and the first switch is open. This results in a parallel connection of the first and the second capacitances in respect to the first terminal.

Because of the pre-charging of the second capacitance, the charge transfer occurring at the first terminal when switching from the first mode of operation to the second mode of operation is minimized. Consequently, also a voltage step at the first terminal resulting from the charge transfer is minimized. Using the buffer, a different initial condition is created.

In several embodiments, the buffer comprises an operational amplifier with an offset voltage.

The operational amplifier is preferably implemented in a non-inverting configuration with a gain equal to 1. The offset voltage represents the input offset of the operational amplifier which preferably is in the range between 1 and 10 mV.

In another exemplary embodiment, a control voltage is provided at the first terminal in the first mode of operation comprising a value of a first voltage of the first capacitance. In the second mode of operation, the control voltage is provided at the first terminal comprising the sum of the first voltage and the offset voltage.

The above-mentioned voltage step is represented by the difference between the value of the control voltage provided in the first mode of operation and the value of the control voltage in the second mode of operation. The value of the offset voltage of the buffer amounts to this difference. As it is in the range of milli-volts, this is an improvement compared to a state-of-the-art implementation using simple switching of several discrete capacitors where the voltage step would be in the range of volts.

In one exemplary embodiment, a low pass filter arrangement comprises a variable capacitance circuit and a charge pump which is coupled to the first terminal providing an input current.

The charge pump provides an input current to the first terminal of the variable capacitance circuit. The variable capacitance circuit integrates this input current. Consequently, the variable capacitance circuit is designated as low pass filter providing a variable bandwidth resulting from the variable capacitances.

In another exemplary embodiment, a first low pass filter is connected between the first terminal and the reference potential terminal. A second low pass filter is connected between the second terminal and the reference potential terminal. The first low pass filter provides a first time constant and comprises the first capacitance of the variable capacitance circuit. The second low pass filter provides a second time constant which differs from the first time constant. The second low pass filter comprises the second capacitance of the variable capacitance circuit.

In another exemplary embodiment, the first low pass filter further comprises a serial connection having an input capacitor and an input resistor coupled to the reference potential terminal, said serial connection coupled in parallel with the first capacitance. The second low pass filter further comprises a serial connection having an output capacitor and an output resistor coupled to the reference potential terminal, said serial connection coupled in parallel with the second capacitance.

In the first mode of operation, the time constant of the first low pass filter which corresponds to a first bandwidth is provided at the first terminal. At the same time, the capacitances of the second low pass filter are pre-charged via the buffer. When switching from the first mode of operation to the second mode of operation, the first and the second low pass filter are combined resulting in a change in bandwidth. Because of the pre-charging mechanism that is applied to the second low pass filter, the voltage step occurring at the first terminal is in the range of milli-volts and therefore, the loop disturbance is kept at a minimum.

In another exemplary embodiment, a charge-switch is connected in parallel to the output resistor and is related to the reference potential terminal.

The charge-switch is closed in the first mode of operation and it is open in the second mode of operation. Consequently, in the first mode of operation, the output resistor is shorted which minimizes the time of the charge build-up on the output capacitor.

In another exemplary embodiment, the charge pump comprises a switchable positive current source and a switchable negative current source. The positive and negative current sources are coupled in parallel to each other between the reference potential terminal and the first terminal.

The switchable current sources are operated independently of the first and the second mode of operation.

In one exemplary embodiment, a phase-locked loop arrangement comprises a low pass filter arrangement, a voltage-controlled oscillator, and a phase detector. The voltage-controlled oscillator has an input to be supplied with a second control voltage either from the first terminal via a lock-in switch during the first mode of operation or from the second terminal via a loop-switch during the second mode of operation. The voltage-controlled oscillator further has an output to provide an output frequency as a function of the second control voltage..The phase detector has a first input to receive a reference frequency, a second input which is coupled to the output of the voltage-controlled oscillator, a first output to provide a first control signal to the switchable positive current source and a second output to provide a second control signal to the switchable negative current source. The control signals are provided as a function of a phase difference between the output frequency and the reference frequency.

The second control voltage thereby corresponds to the directional signal.

In this embodiment, the first mode of operation represents an initial lock-in process of the phase-locked loop arrangement which preferably works at high bandwidth. The control voltage which corresponds in this embodiment to the error signal of a PLL is building up the charge on the second low pass filter via the buffer. The buffer and the second low pass filter appear out of the PLL loop in the first mode of operation, thus not interfering with the PLL dynamics. After reaching phase coherence at the wide bandwidth and after the charge on the second low pass filter is built up with sufficiently low residual error, the phase-locked loop arrangement is switched to the second mode of operation. Thereby, the buffer is disconnected and the second low pass filter is directly connected to the first low pass filter by the second switch. This represents a pole-zero relocation and results in this embodiment in a bandwidth reduction which achieves a better reference frequency spur attenuation.

As a result, the bandwidth and the damping factor of the PLL arrangement remain two independent design variables. This means that two bandwidth settings can be designed with unchanged damping factor. During the dynamic process of pole-zero relocation when switching from the first mode of operation to the second mode of operation, the loop phase coherence is only slightly disturbed although a significant bandwidth change, for example by the factor of 10 or higher, is realized.

The voltage step introduced by the buffer's offset voltage can even be eliminated by offset calibration.

In another exemplary embodiment, the phase-locked loop arrangement further comprises a frequency divider with an input coupled to the output of the voltage-controlled oscillator and an output coupled to the second input of the phase detector. The output provides a fraction of the output frequency.

Using the frequency divider, the phase-locked loop arrangement can be employed as a frequency synthesizer.

Another aspect of the invention is related to ESD protection. ESD represents an electrostatic discharge. A typical implementation of the phase-locked loop arrangement on an integrated circuit in CMOS technology requires an electrostatic discharge protection circuit connected to each pin. The electrostatic discharge protection is depicted as first, second, and third ESD-resistor, with an exemplary value of several hundreds of ohms.

In another exemplary embodiment, the loop-switch is coupled to the second terminal via a first ESD-resistor. The first and the second switches of the variable capacitance circuit are coupled to the second terminal via a second ESD-resistor.

In another exemplary embodiment, the charge-switch is coupled to the output resistor via a third ESD-resistor.

During the first mode of operation, representing the wide bandwidth mode of the phase-locked loop arrangement, the first, second, and third ESD-resistors are not part of the phase-locked loop. Therefore, the loop dynamics are not altered by these resistors. In the second mode of operation, which depicts the low or narrow bandwidth mode of the PLL arrangement, the first and the second ESD-resistors create insignificant high frequency poles. They have no influence on the PLL dynamic behavior.

Consequently, a proper ESD-protection is provided to the PLL arrangement, avoiding the creation of undesired zeroes in the low pass filter. The loop dynamics are not influenced.

One exemplary embodiment of a method for providing a variable capacitance comprises a first mode of operation and a second mode of operation. The first mode of operation comprises the closing of a first switch and opening of a second switch, the charging of a first capacitance coupled between a first terminal and a reference potential, the pre-charging of a second capacitance via a buffer, and providing the value of a first capacitance and a first value of a control voltage at the first terminal. The second capacitance is coupled between a second terminal and the reference potential terminal. The buffer is coupled by its input terminal to the first terminal and by its output terminal to the second terminal via the first switch. The second switch directly connects the first terminal with the second terminal. The second mode of operation comprises opening the first switch and closing the second switch, effectively combining the first capacitance with the second capacitance, and providing the value of the combined capacitances and a second value of the control voltage. Thereby, a second value of the control voltage is equal to or is differing negligibly from the first value of the control voltage at the first terminal.

By means of pre-charging the second capacitance, a charge transfer between the two capacitances is avoided when switching from first to second mode of operation. This results in very little disturbance of a loop circuit during the pole-zero relocation.

A control signal required to operate the switches of the PLL arrangement can be implemented as a delay signal, for example by a digital counter. The delay of this signal with respect to the lock-in start, for instance, is either approximated or automated by a circuit detecting the PLL arrangement's steady state during the initial wide bandwidth mode or the first mode of operation.

The text below explains the invention in detail using exemplary embodiments with reference to the drawings, in which:

FIG. 1    shows an exemplary embodiment of a variable capacitance circuit,

FIG. 2    shows an exemplary embodiment of a low pass filter arrangement, and

FIG. 3    shows an exemplary embodiment of a phase-locked loop arrangement.

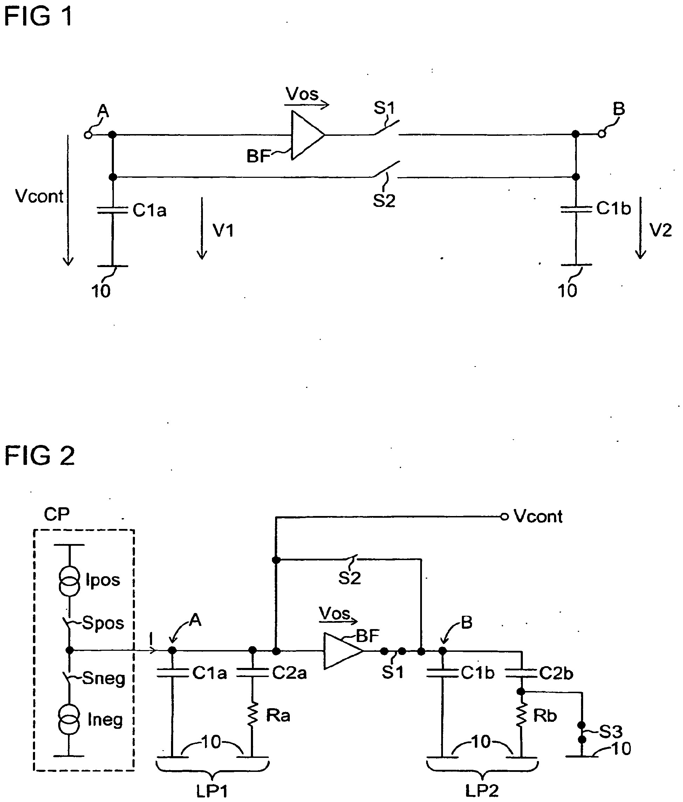

FIG. 1 shows an exemplary embodiment of a variable capacitance circuit. The circuit comprises a first capacitance C1a, a second capacitance C1b, a buffer BF, a first switch S1 and a second switch S2. The first capacitance C1a is coupled between a first terminal A and a reference potential terminal 10. The second capacitance C1b is coupled between.a second terminal B and the reference potential terminal 10. An input terminal of the buffer BF is coupled to the first terminal A. An output terminal of the buffer BF is coupled to the second terminal B via the first switch S1. The second switch S2 directly connects the first terminal A with the second terminal B.

The buffer BF is implemented, for example, as an operational amplifier in a non-inverting configuration with the gain 1. The input offset is in the range of 1 to 10 mV. The input and output voltage range covers, for example, the range of the control voltage Vcont. The input and output voltage range can also cover the range from 0 V to the supply voltage in a rail-to-rail operational amplifier.

In a first mode of operation, the first switch S1 is closed and the second switch S2 is open. The first capacitance C1a is charged to a first voltage V1. The second capacitance C1b is pre-charged to a second voltage V2 via the buffer BF. A control voltage Vcont is provided at the first terminal A. A first value of the control voltage Vcont equals the value of the first voltage V1 at the first capacitance C1a. The buffer BF has an offset voltage Vos. The value of the second voltage V2 at the second capacitance C1b equals the sum of the value of the control voltage Vcont and the offset voltage Vos.

In a second mode of operation, the first switch S1 is off, and the second switch S2 is on. This disconnects the buffer BF and directly couples the first and the second capacitances C1a and C1b in a parallel configuration in respect to the first terminal A. According to the Kirchhoff law, the transient process is described by the following equations:

$$C1 \cdot \frac{dV1}{dt} - C2 \cdot \frac{dV2}{dt} = 0 \qquad (1)$$

$$R \cdot C1 \cdot \frac{dV1}{dt} + V1 + V2 = 0 \qquad (2)$$

C1 represents the value of the first capacitance C1a, C2 represents the value of the second capacitance C1b, V1 represents the value of the first voltage V1, V2 represents the value of the second voltage V2, R represents the value of the overall resistance including, for example, the respective switch resistance of the first and the second switches S1 and S2 and the output resistance of the buffer BF.

A voltage step applied to the control voltage Vcont after integration of equations (1) and (2) can be described as:

$$(V1 - V2) \cdot \frac{C1}{C1 + C2} .$$

Taking into account that the second voltage V2 equals the sum of the control voltage Vcont plus the offset voltage Vos, the voltage step applied to the control voltage Vcont is

$$Vos \cdot \frac{C1}{C1 + C2} .$$

Vos represents the value of the offset voltage Vos.

As can be seen from the calculations, the voltage step applied to the control voltage Vcont is in the range of the offset voltage Vos which is in the range of 1 to 10 mV.

In a state-of-the-art implementation without pre-charging, the second voltage V2 would be equal 0 V in the first mode of operation. Therefore, the voltage step applied to the control voltage Vcont when switching to the second mode of operation would be in the range of Volt.

Consequently, the voltage step input magnitude is significantly reduced by the pre-charging mechanism which creates a different initial condition.

FIG. 2 shows an exemplary embodiment of a low pass filter arrangement. The arrangement comprises a charge pump CP, a first low pass filter LP1, a second low pass filter LP2, a charge-switch S3, the first and second switches S1 and S2, and the buffer BF. The first low pass filter LP1 is connected between the first terminal A and the reference potential terminal 10. It comprises the first capacitance C1a of the variable capacitance circuit of FIG. 1. The first low pass filter LP1 further comprises a serial connection having an input capacitor C2a and an input resistor Ra coupled to the reference potential terminal 10. This serial connection is coupled in parallel to the first capacitance C1a. The second low pass filter LP2 comprises the second capacitance C1b of the variable capacitance circuit of FIG. 1. It further comprises a serial connection having an output capacitor C2b and an output resistor Rb coupled to the reference potential terminal 10. This serial connection is coupled in parallel to the second capacitance C1b. The charge-switch S3 is coupled between the output resistor Rb and the reference potential terminal 10.

The charge pump CP comprises a switchable positive current source Ipos and a switchable negative current source Ineg. The positive and negative current sources Ipos and Ineg are coupled in parallel to each other between the reference potential terminal 10 and the first terminal A. The positive current source Ipos is switched by a positive switch Spos. The negative current source Ineg is switched by a negative switch Sneg. The charge pump CP provides an input current I to the first terminal A. The input current I is integrated by the first and the second low pass filters LP1 and LP2.

The connection and functioning of the buffer BF, and the first and second switches S1 and S2 correspond to the description under FIG. 1. The control voltage Vcont is provided at the first terminal A.

In the first mode of operation, the first switch S1 and the charge-switch S3 are closed, the second switch S2 is open. The first capacitance C1a and the input capacitor C2a of the first low pass filter LP1 are charged. The second capacitor C1b as well as the output capacitor C2b are pre-charged via the buffer BF. As the output resistor Rb is shortened by the charge-switch S3, the time of charge build-up on the output capacitor C2b is minimized. The value of the capacitance of the first low pass filter LP1, which corresponds to a first bandwidth, is provided at the first terminal A.

In the second mode of operation, the second switch S2 is closed, the first switch S1 and the charge-switch S3 are open. The first low pass filter LP1 is coupled to the second low pass filter LP2 providing the value of the combined capacitances, which corresponds to a second bandwidth at the first terminal A.

The positive and negative switches Spos and Sneg of the charge pump CP are operated independently from the first and the second mode of operation.

Switching from the first mode of operation to the second mode of operation implies a change in bandwidth of the low pass filter arrangement. In the frequency domain or in the S plane, this can be described as a pole-zero relocation. Because of the pre-charging of the second low pass filter LP2, the voltage step applied to the control voltage Vcont is characterized by the offset voltage Vos of the buffer BF. As the offset voltage Vos is in the range of 1 to 10 mV, the disturbance of the loop introduced by the pole-zero relocation is minimized.

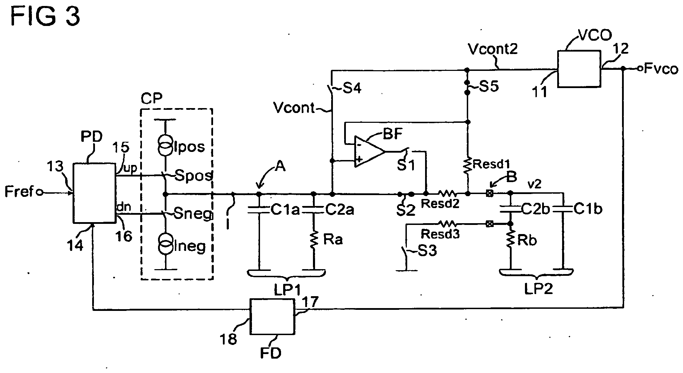

FIG. 3 shows an exemplary embodiment of a phase-locked loop arrangement. The phase locked-loop arrangement comprises a low pass filter arrangement as described in FIG. 2. It additionally comprises a voltage-controlled oscillator VCO, a phase detector PD, and an optional frequency divider FD. The voltage-controlled oscillator VCO has an input 11 which is supplied with a second control voltage Vcont2 either from the first terminal A via a lock-in switch S4 during the first mode of operation or from the second terminal B via a loop-switch S5 during the second mode of operation. The voltage-controlled oscillator VCO has an output 12 to provide an output frequency Fvco.

The optional frequency divider FD has an input 17 which is coupled to the output 12 of the voltage-controlled oscillator VCO. An output 18 of the frequency divider FD is coupled to a second input 14 of the phase detector PD. The frequency divider FD provides a fraction of the output frequency Fvco of the voltage-controlled oscillator VCO. When the phase-locked loop arrangement is used, for example, as frequency synthesizer, the frequency divider FD is present. Otherwise, the output 12 of the voltage-controlled oscillator VCO is directly coupled to the second input 14 of the phase detector PD.

The phase detector PD has a first input 13 to receive a reference frequency Fref. It further has a first output 15 to provide a first control signal up to the switchable positive current source Ipos of the charge pump CP and a second output 16 to provide a second control signal dn to the switchable negative current source Ineg of the charge pump CP. The first and second control signals up and dn are provided as a function of a phase difference between the output frequency Fvco of the voltage-controlled oscillator VCO and the reference frequency Fref provided to the phase detector PD. This means that the input current I generated by the charge pump CP in average is proportional to the phase difference between the output frequency Fvco and the reference frequency Fref.

In this embodiment, the PLL arrangement is realized with two bandwidth modes. The bandwidth ratio achieved is in the order of tens or higher. As the first and second capacitances C1a and C1b are a square function of the PLL bandwidth, a capacitance variation by factor of 100 is required. The first low pass filter LP1 determines a wide bandwidth mode whereas the second low pass filter LP2 determines a narrow bandwidth mode. Because of the large capacitances, the components of the second low pass filter LP2 are implemented in this embodiment externally to the integrated circuit which comprises the rest of the PLL arrangement which can be realized as part of a printed circuit board assembly.

Furthermore, an electrostatic discharge, ESD, protection is provided in this embodiment as required for a typical CMOS integrated circuit. This ESD-protection is depicted as a first, a second and a third ESD-resistor Resd1, Resd2, and Resd3. The first ESD-resistor Resd1 is coupled between the second terminal B and the loop-switch S5. The second ESD-resistor Resd2 is coupled between the second terminal B and the second switch S2. The third ESD-resistor Resd3 is coupled between the output resistor Rb and the charge-switch S3.

The buffer BF is implemented as operational amplifier with its positive input terminal coupled to the first terminal A, and its output terminal coupled to the first switch S1. Coupling its negative input terminal to the loop-switch S5 realizes a negative feedback.

The first mode of operation depicts the wide bandwidth mode of the PLL arrangement representing the lock-in phase. In this mode, the second switch S2 and the loop-switch S5 are open. The first switch S1, the charge-switch S3 and the lock-in switch S4 are closed. The first low pass filter LP1 determines the bandwidth of the PLL arrangement, whereas the second low pass filter LP2 is pre-charged via the buffer BF.

The buffer BF and the second low pass filter LP2 appear outside of the PLL loop in this mode, thus not interfering with the PLL dynamics. As the feedback of the buffer BF is closed at the second terminal B, the equivalent impedance at the second terminal B is reduced because of the loop gain of the operational amplifier. This results in speeding up the charge build-up on the capacitances of the second low pass filter LP2. After reaching phase coherence in the first mode of operation and after the charge on the second low pass filter LP2 has built up, the PLL arrangement is switched to the second mode of operation.

The second mode of operation realizes the narrow bandwidth mode. The first switch S1, the lock-in switch S4, and the charge-switch S3 are open. The second switch S2 and the loop-switch S5 are closed. As the second control signal Vcont2 is connected to the second terminal B, the second ESD-resistor Resd2 is bypassed and the impedance at high frequency is low. The first and second ESD-resistors Resd1 and Resd2 create insignificant high frequency poles which have no influence on the PLL dynamic behavior. The parasitic effect of these resistors is greatly reduced.

In summary, the dynamic process of the pole-zero relocation only slightly disturbs the loop phase coherence even if significant bandwidth change is realized. This enables the use of such a PLL arrangement in frequency agile electronic systems which require a PLL output signal as characterized by a narrow bandwidth PLL. Furthermore, the ESD-resistors do not alter the significant pole-zero locations.

Reference list

| | |
|---|---|
| A | first terminal |
| B | second terminal |
| C1a, C1b, C2a, C2b | capacitance |
| BF | buffer |
| S1, S2, S3, S4, S5 | switch |
| R1, R2, Ra, Rb | resistor |
| Resd1, Resd2, Resd3 | resistor |
| Vos, Vcont, Vcont2, V1, V2 | voltage |
| CP | charge pump |
| LP1, LP2 | low pass filter |
| 10 | reference potential terminal |
| 11, 13, 14, 17 | input |
| 12, 15, 16, 18 | output |
| Ipos, Ineg | current source |
| VCO | voltage-controlled oscillator |
| Fvco, Fref | frequency |
| PD | phase detector |
| up, dn | control signal |
| FD | frequency divider |

I                              input current


**Claims**

1. Variable capacitance circuit comprising

    - a first capacitance (C1a) coupled between a first terminal (A) and a reference potential terminal (10),
    - a second capacitance (C1b) coupled between a second terminal (B) and the reference potential terminal (10),
    - a switchable connection between the first terminal (A) and the second terminal (B), configured such that in a first mode of operation the value of the first capacitance (C1a) is provided at the first terminal (A) and that in a second mode of operation a sum of the values of the first and the second capacitances (C1a, C1b) is provided at the first terminal (A),
    the variable capacitance circuit being **characterized by** having
    - a buffer (BF), wherein in the first mode of operation the buffer (BF) is effectively coupled between the first terminal (A) and the second terminal (B) via a first switch (S1) and in the second mode of operation the first terminal (A) is effectively connected to the second terminal (B) via a second switch (S2).

2. Variable capacitance circuit according to claim 1,
    wherein the buffer (BF) comprises an operational amplifier with an offset voltage (Vos).

3. Variable capacitance circuit according to claim 2,
    wherein a control voltage (Vcont) is provided at the first terminal (A) in the first mode of operation comprising a value of a first voltage (V1) of the first capacitance (C1a) and wherein the control voltage (Vcont) is provided at the first terminal (A) in the second mode of operation comprising the sum of the first voltage (V1) and the offset voltage (Vos).

4. Low pass filter arrangement comprising

    - a variable capacitance circuit according to claim 3, and
    - a charge pump (CP) which is coupled to the first terminal (A) providing an input current (I).

5. Low pass filter arrangement according to claim 4,
    wherein

    - a first low pass filter (LP1) is connected between the first terminal (A) and the reference potential terminal (10) providing a first time constant and comprising the first capacitance (C1a) of the variable capacitance circuit, and
    - a second low pass filter (LP2) is connected between the second terminal (B) and the reference potential terminal (10) providing a second time constant differing from the first time,constant and comprising the second capacitance (C1b) of the variable capacitance circuit.

6. Low pass filter arrangement according to claim 5,
    wherein

    - the first low pass filter (LP1) further comprises a serial connection having an input capacitor (C2a) and an input resistor (Ra) coupled to the reference potential terminal (10), said serial connection coupled in parallel with the first capacitance (C1a), and
    - the second low pass filter (LP2) further comprises a serial connection having an output capacitor (C2b) and an output resistor (Rb) coupled to the reference potential terminal (10), said serial connection coupled in parallel with the second capacitance (C1b).

7. Low pass filter arrangement according to claim 6,
    wherein a charge-switch (S3) is connected in parallel to the output resistor (Rb) and is related to the reference potential terminal (10).

8. Low pass filter arrangement according to one of claims 4 to 7,
    wherein the charge pump (CP) comprises a switchable positive current source (Ipos) and a switchable negative current source (Ineg), with said positive and negative current sources (Ipos, Ineg) coupled in parallel to each other between the reference potential terminal (10) and the first terminal (A).

9. Phase-locked loop arrangement comprising,

- a low pass filter arrangement according to claim 8,
- a voltage-controlled oscillator (VCO) with an input (11) to be supplied with a second control voltage (Vcont2) either from the first terminal (A) via a lock-in switch (S4) during the first mode of operation or from the second terminal (B) via a loop-switch (S5) during the second mode of operation, and with an output (12) to provide an output frequency (Fvco) as a function of the second control voltage (Vcont2),
- a phase detector (PD) with a first input (13) to receive a reference frequency (Fref), a second input (14) coupled to the output (12) of the voltage-controlled oscillator (VCO), a first output (15) to provide a first control signal (up) to the switchable positive current source (Ipos) and a second output (16) to provide a second control signal (dn) to the switchable negative current source (Ineg), said control signals (up, dn) provided as a function of a phase difference between the output frequency (Fvco) and the reference frequency (Fref).

10. Phase-locked loop arrangement according to claim 9, further comprising a frequency divider (FD) with an input (17) coupled to the output (12) of the voltage-controlled oscillator (VCO) and an output (18) coupled to the second input (14) of the phase detector (PD) and providing a fraction of the output frequency (Fvco).

11. Phase-locked loop arrangement according to claim 9 or 10, wherein the loop-switch (S5) is coupled to the second terminal (B) via a first ESD-resistor (Resd1), and the first and the second switches (S1, S2) of the variable capacitance circuit are coupled to the second terminal (B) via a second ESD-resistor (Resd2).

12. Phase-locked loop arrangement according to one of claims 9 to 11, wherein a charge-switch (S3) is connected in parallel to the output resistor (Rb) via a third ESD-resistor (Resd3), the charge-switch (S3) being related to the reference potential terminal (10).

13. Method for providing a variable capacitance, comprising

- in a first mode of operation:

    - closing a first switch (S1) and opening a second switch (S2),
    - charging a first capacitance (C1a) coupled between a first terminal (A) and a reference potential terminal (10),
    the method being **characterized by** comprising in the first mode of operation
    - pre-charging a second capacitance (C1b) via a buffer (BF), the second capacitance (C1b) being coupled between a second terminal (B) and the reference potential terminal (10), wherein the buffer (BF) is coupled by its input terminal to the first terminal (A) and by its output terminal to the second terminal (B) via the first switch (S1), and wherein the second switch (S2) directly connects the first terminal (A) with the second terminal (B),
    - providing the value of the first capacitance (C1a) and a first value of a control voltage (Vcont) at the first terminal (A), and

- in a second mode of operation:

    - opening the first switch (S1) and closing the second switch (S2),
    - effectively combining the first capacitance (C1a) with the second capacitance (C1b),
    - providing the value of the combined capacitances (C1a, C1b) and a second value of the control voltage (Vcont) being equal to or differing negligibly from the first value of the control voltage (Vcont) at the first terminal (A).

**Patentansprüche**

1. Schaltung mit variabler Kapazität, aufweisend

    - eine erste Kapazität (C1a), die zwischen einen ersten Anschluss (A) und einen Bezugspotentialanschluss (10) gekoppelt ist,
    - eine zweite Kapazität (C1b), die zwischen einen zweiten Anschluss (B) und den Bezugspotentialanschluss (10) gekoppelt ist,
- eine schaltbare Verbindung zwischen dem ersten Anschluss (A) und dem zweiten Anschluss (B), welche derart eingerichtet ist, dass in einem ersten Betriebsmodus der Wert der ersten Kapazität (C1a) an dem ersten Anschluss (A) bereitgestellt wird und dass in einem zweiten Betriebsmodus eine Summe der Werte der ersten und der zweiten Kapazität (C1a, C1b) an dem ersten Anschluss (A) bereitgestellt wird,

wobei die Schaltung mit variabler Kapazität **dadurch gekennzeichnet ist, dass** sie
einen Puffer (BF) aufweist, wobei in dem ersten Betriebsmodus der Puffer (BF) zwischen den ersten Anschluss (A) und den zweiten Anschluss (B) über einen ersten Schalter (S1) wirkgekoppelt ist und in dem zweiten Betriebsmodus der erste Anschluss (A) mit dem zweiten Anschluss (B) über einen zweiten Schalter (S2) wirkverbunden ist.

2. Schaltung mit variabler Kapazität nach Anspruch 1, wobei der Puffer (BF) einen Operationsverstärker mit einer Offset-Spannung (Vos) aufweist.

3. Schaltung mit variabler Kapazität nach Anspruch 2, wobei eine Steuerspannung (Vcont) an dem ersten Anschluss (A) in dem ersten Betriebsmodus aufweisend einen Wert einer ersten Spannung (V1) der ersten Kapazität (C1a) bereitgestellt ist, und wobei die Steuerspannung (Vcont) an dem ersten Anschluss (A) in dem zweiten Betriebsmodus aufweisend die Summe aus der ersten Spannung (V1) und der Offset-Spannung (Vos) bereitgestellt ist.

4. Tiefpassfilteranordnung, aufweisend:

- eine Schaltung mit variabler Kapazität gemäß Anspruch 3, und
- eine Ladungspumpe (CP), welche an den ersten Anschluss (A) gekoppelt ist und einen Eingangsstrom (I) bereitstellt.

5. Tiefpassfilteranordnung nach Anspruch 4,
wobei

- ein erster Tiefpassfilter (LP1) zwischen dem ersten Anschluss (A) und dem Bezugspotentialanschluss (10) angeschlossen ist und eine erste Zeitkonstante bereitstellt und die erste Kapazität (C1a) der Schaltung mit variabler Kapazität aufweist, und
- ein zweiter Tiefpassfilter (LP2) zwischen dem zweiten Anschluss (B) und dem Bezugspotentialanschluss (10) angeschlossen ist und eine zweite, von der ersten Zeitkonstante verschiedene Zeitkonstante bereitstellt und die zweite Kapazität (C1b) des Schaltkreises mit variabler Kapazität aufweist.

6. Tiefpassfilteranordnung nach Anspruch 5,
wobei

- der erste Tiefpassfilter (LP1) ferner eine Reihenschaltung mit einem Eingangskondensator (C2a) und einem Eingangswiderstand (Ra), der mit dem Bezugspotentialanschluss (10) gekoppelt ist, aufweist, wobei diese Reihenschaltung zu der ersten Kapazität (C1a) parallel geschaltet ist, und
- der zweite Tiefpassfilter (LP2) ferner eine Reihenschaltung mit einem Ausgangskondensator (C2b) und einem Ausgangswiderstand (Rb), der mit dem Bezugspotentialanschluss (10) gekoppelt ist, aufweist, wobei diese Reihenschaltung zu der zweiten Kapazität (C1b) parallel geschaltet ist.

7. Tiefpassfilteranordnung nach Anspruch 6,
wobei ein Ladeschalter (S3) zu dem Ausgangswiderstand (Rb) parallel geschaltet und auf den Bezugspotentialanschluss (10) bezogen ist.

8. Tiefpassfilteranordnung nach einem der Ansprüche 4 bis 7,
wobei die Ladungspumpe (CP) eine schaltbare positive Stromquelle (Ipos) und eine schaltbare negative Stromquelle (Ineg) aufweist, wobei diese positiven und negativen Stromquellen (Ipos, Ineg) zueinander parallelgeschaltet zwischen den Bezugspotentialanschluss (10) und den ersten Anschluss (A) gekoppelt sind.

9. Phasenregelschleifenanordnung, aufweisend,

- eine Tiefpassfilteranordnung nach Anspruch 8,
- einen spannungsgesteuerten Oszillator (VCO) mit einem Eingang (11) zum Versorgen mit einer zweiten Steuerspannung (Vcont2) entweder von dem ersten Anschluss (A) über einen Einrast-Schalter (S4) während des ersten Betriebsmodus oder von dem zweiten Anschluss (B) über einen Schleifenschalter (S5) während des zweiten Betriebsmodus, und mit einem Ausgang (12) zum Ausgeben einer Ausgangsfrequenz (Fvco) als Funktion der zweiten Steuerspannung (Vcont2),

- einen Phasendetektor (PD) mit einem ersten Eingang (13), um eine Referenzfrequenz (Fref) aufzunehmen, einem zweiten Eingang (14), der an den Ausgang (12) des spannungsgesteuerten Oszillators (VCO) gekoppelt ist, einem ersten Ausgang (15), zum Bereitstellen eines ersten Steuersignals (up) für die schaltbare positive Stromquelle (Ipos), und einem zweiten Ausgang (16), zum Bereitstellen eines zweiten Steuersignals (dn) für die schaltbare negative Stromquelle (Ineg), wobei diese Steuersignale (up, dn) als Funktion einer Phasendifferenz zwischen der Ausgangsfrequenz (Fvco) und der Referenzfrequenz (Fref) bereitgestellt werden.

10. Phasenregelschleifenanordnung nach Anspruch 9, ferner aufweisend einen Frequenzteiler (FD) mit einem Eingang (17), der an den Ausgang (12) des spannungsgesteuerten Oszillators (VCO) gekoppelt ist, und mit einem Ausgang (18), der an den zweiten Eingang (14) des Phasendetektors (PD) gekoppelt ist und einen Bruchteil der Ausgangsfrequenz (Fvco) bereitstellt.

11. Phasenregelschleifenanordnung nach Anspruch 9 oder 10, wobei der Schleifenschalter (S5) über einen ersten ESD-Widerstand (Resd1) an den zweiten Anschluss (B) gekoppelt ist, und der erste und der zweite Schalter (S1, S2) der Schaltung mit variabler Kapazität über einen zweiten ESD-Widerstand (Resd2) an den zweiten Anschluss (B) gekoppelt sind.

12. Phasenregelschleifenanordnung nach einem der Ansprüche 9 bis 11, wobei ein Ladeschalter (S3) mit dem Ausgangswiderstand (Rb) über einen dritten ESD-Widerstand (Resd3) parallel geschaltet ist, wobei der Ladeschalter (S3) auf den Bezugspotentialanschluss (10) bezogen ist.

13. Verfahren zum Bereitstellen einer variablen Kapazität, umfassend:

- in einem ersten Betriebsmodus:

- Schließen eines ersten Schalters (S1) und Öffnen eines zweiten Schalters (S2),
- Laden einer ersten Kapazität (C1a), die zwischen einen ersten Anschluss (A) und einen Bezugspotentialanschluss (10) gekoppelt ist, wobei das Verfahren **dadurch gekennzeichnet ist, dass** es in dem ersten Betriebsmodus umfasst:
- Vorladen einer zweiten Kapazität (C1b) über einen Puffer (BF), wobei die zweite Kapazität (C1b) zwischen einen zweiten Anschluss (B) und den Bezugspotentialanschluss (10) gekoppelt ist, wobei der Puffer (BF) durch seinen Eingangsanschluss an den ersten Anschluss (A) gekoppelt ist und durch seinen Ausgangsanschluss über den ersten Schalter (S1) an den zweiten Anschluss (B) gekoppelt ist, und wobei der zweite Schalter (S2) den ersten Anschluss (A) unmittelbar mit dem zweiten Anschluss (B) verbindet,
- Bereitstellen des Werts der ersten Kapazität (C1a) und eines ersten Werts einer Steuerspannung (Vcont) an dem ersten Anschluss (A), und

- in einem zweiten Betriebsmodus:

- Öffnen des ersten Schalters (S1) und Schließen des zweiten Schalters (S2),
- wirksames Kombinieren der ersten Kapazität (C1a) mit der zweiten Kapazität (C1b),
- Bereitstellen des Werts der kombinierten Kapazitäten (C1a, C1b) und eines zweiten Werts der Steuerspannung (Vcont), der gleich dem ersten Wert der Steuerspannung (Vcont) an dem ersten Anschluss (A) ist oder vernachlässigbar von diesem abweicht.

**Revendications**

1. Circuit à capacité variable, comprenant :

- une première capacité (C1a) couplée entre une première borne (A) et une borne de potentiel de référence (10) ;
- une seconde capacité (C1b) couplée entre une seconde borne (B) et la borne de potentiel de référence (10) ;
- une connexion commutable entre la première borne (A) et la seconde borne (B), configurée de telle sorte que dans un premier mode de fonctionnement, la valeur de la première capacité (C1a) est fournie sur la première borne (A) et que, dans un second mode de fonctionnement, une somme des valeurs de première capacité et seconde capacité (C1a, C1b) est fournie sur la première borne (A), le circuit à capacité variable étant **caractérisé par le fait qu'**il présente

- un tampon (BF), qui dans le premier mode de fonctionnement est couplé effectivement entre la première borne (A) et la seconde borne (B) par un premier commutateur (S1), et dans le second mode de fonctionnement, la première borne (A) est couplée effectivement avec la seconde borne (B) par un second commutateur (S2).

2. Circuit à capacité variable selon la revendication 1, dans lequel le tampon (BF) comprend un amplificateur opérationnel présentant une tension de décalage (Vos).

3. Circuit à capacité variable selon la revendication 2, dans lequel une tension de commande (Vcont) est fournie sur la première borne (A) dans le premier mode de fonctionnement comprenant une valeur d'une première tension (V1) de la première capacité (C1a), et dans lequel la tension de commande (Vcont) est fournie à la première borne (A) dans le second mode de fonctionnement comprenant la somme de la première tension (V1) et de la tension de décalage (Vos).

4. Agencement de filtre passe-bas, comprenant :

    - un circuit à capacité variable selon la revendication 3, et
    - une pompe de charge (CP) couplée avec la première borne (A) fournissant un courant d'entrée (I).

5. Agencement de filtre passe-bas selon la revendication 4, dans lequel

    - un premier filtre passe-bas (LP1) est connecté entre la première borne (A) et la borne de potentiel de référence (10) fournissant une première constante de temps et comprenant la première capacité (C1a) du circuit à capacité variable, et
    - un second filtre passe-bas (LP2) est connecté entre la seconde borne (B) et la borne de potentiel de référence (10) fournissant une seconde constante de temps différant de la première constante de temps et comprenant la seconde capacité (C1b) du circuit à capacité variable.

6. Agencement de filtre passe-bas selon la revendication 5, dans lequel

    - le premier filtre passe-bas (LP1) comprend en outre une connexion série présentant un condensateur d'entrée (C2a) et une résistance d'entrée (Ra) couplée avec la borne de potentiel de référence (10), ladite connexion série étant couplée en parallèle avec la première capacité (C1a), et
    - le second filtre passe-bas (LP2) comprend en outre une connexion série présentant un condensateur de sortie (C2b) et une résistance de sortie (Rb) couplée avec la borne de potentiel de référence (10), ladite connexion série étant couplée en parallèle avec la seconde capacité (C1b).

7. Agencement de filtre passe-bas selon la revendication 6, dans lequel un commutateur de charge (S3) est relié en parallèle avec la résistance de sortie (Rb) et est lié à la borne de potentiel de référence (10).

8. Agencement de filtre passe-bas selon l'une quelconque des revendications 4 à 7, dans lequel la pompe de charge (CP) comprend une source de courant positive commutable (Ipos) et une source de courant négative commutable (Ineg), lesdites sources de courant positive et négative (Ipos, Ineg) étant couplées en parallèle l'une avec l'autre entre la borne de potentiel de référence (10) et la première borne (A).

9. Agencement de boucle à verrouillage de phase, comprenant :

    - un agencement de filtre passe-bas selon la revendication 8,
    - un oscillateur commandé en tension (VCO) présentant une entrée (11) à alimenter avec une seconde tension de commande (Vcont2), soit à partir de la première borne (A) par un commutateur de verrouillage (S4) durant le premier mode de fonctionnement, soit à partir de la seconde borne (B) par un commutateur à boucle (S5) durant le second mode de fonctionnement, et présentant une sortie (12) afin de fournir une fréquence de sortie (Fvco) en tant que fonction de la seconde tension de commande (Vcont2),
    - un détecteur de phase (PD) présentant une première entrée (13) afin de recevoir une fréquence de référence (Fref), une seconde entrée (14) couplée avec la sortie (12) de l'oscillateur commandé en tension (VCO), une première sortie (15) afin de fournir un premier signal de commande (up) à la source de courant positive commutable (Ipos) et une seconde sortie (16) afin de fournir un second signal de commande (dn) à la source de courant négative commutable (Ineg), lesdits signaux de commande (up, dn) étant fournis en tant que fonction d'une différence de phase entre la fréquence de sortie (Fvco) et la fréquence de référence (Fref).

**10.** Agencement de boucle à verrouillage de phase selon la revendication 9,
comprenant en outre un diviseur de fréquence (FD) présentant une entrée (17) couplée avec la sortie (12) de l'oscillateur commandé en tension (VCO) et une sortie (18) couplée avec la seconde entrée (14) du détecteur de phase (PD) et fournissant une fraction de la fréquence de sortie (Fvco).

**11.** Agencement de boucle à verrouillage de phase selon la revendication 9 ou 10,
dans lequel le commutateur à boucle (S5) est couplé à la seconde borne (B) par le biais d'une première résistance ESD (Resd1), et les premier et second commutateurs (S1, S2) du circuit à capacité variable sont couplés avec la seconde borne (B) par le biais d'une deuxième résistance ESD (Resd2).

**12.** Agencement de boucle à verrouillage de phase selon l'une quelconque des revendications 9 à 11,
dans lequel un commutateur de charge (S3) est relié en parallèle avec la résistance de sortie (Rb) par le biais d'une troisième résistance ESD (Resd3), le commutateur de charge (S3) étant associé à la borne de potentiel de référence (10).

**13.** Procédé pour fournir une capacité variable, comprenant :

- dans un premier mode de fonctionnement :
- la fermeture d'un premier commutateur (S1) et l'ouverture d'un second commutateur (S2),
- la charge d'une première capacité (C1a) couplée entre une première borne (A) et une borne de potentiel de référence (10) ;

le procédé étant **caractérisé par le fait qu'**il comprend, dans le premier mode de fonctionnement :

- la précharge d'une seconde capacité (C1b) par le biais d'un tampon (BF), la seconde capacité (C1b) étant couplée entre une seconde borne (B) et la borne de potentiel de référence (10), dans lequel le tampon (BF) est couplé par sa borne d'entrée à la première borne (A) et par sa borne de sortie à la seconde borne (B) par le biais du premier commutateur (S1), et dans lequel le second commutateur (S2) directement connecte la première borne (A) avec la seconde borne (B) ;
- la fourniture de la valeur de la première capacité (C1a) et d'une première valeur d'une tension de commande (Vcont) à la première borne (A) et,
- dans un second mode de fonctionnement :
- l'ouverture du premier commutateur (S1) et la fermeture du second commutateur (S2),
- la combinaison de manière effective de la première capacité (C1a) et de la seconde capacité (C1b),
- la fourniture de la valeur des capacités combinées (C1a, C1b) et d'une seconde valeur de la tension de commande (Vcont) égale ou différente de manière négligeable par rapport à la première valeur de la tension de commande (Vcont) à la première borne (A).

FIG 1

FIG 2

# FIG 3

**EP 2 169 828 B1**

**REFERENCES CITED IN THE DESCRIPTION**

**Patent documents cited in the description**

- WO 2004079914 A
- US 20060135105 A1
- US 20030227341 A1